Europäisches Patentamt

European Patent Office

Office européen des brevets

(11) Veröffentlichungsnummer: **0 248 152**
**A1**

# EUROPÄISCHE PATENTANMELDUNG

(21) Anmeldenummer: **87103447.6**

(22) Anmeldetag: **10.03.87**

(51) Int. Cl.⁴: **G01R 15/02 , G01R 33/06**

(30) Priorität: **25.04.86 DE 3613977**

(43) Veröffentlichungstag der Anmeldung:
**09.12.87 Patentblatt 87/50**

(84) Benannte Vertragsstaaten:
**DE FR GB IT SE**

(71) Anmelder: **VDO Adolf Schindling AG**
**Gräfstrasse 103**
**D-6000 Frankfurt/Main(DE)**

(72) Erfinder: **Porth, Wolfgang**
**Röhrborngasse 70**
**D-6000 Frankfurt am Main(DE)**
Erfinder: **Weibler, Wolfgang, Dr.**
**Vor der Heide 14**
**D-6238 Hofheim a. T.(DE)**

(74) Vertreter: **Klein, Thomas, Dipl.-Ing. (FH)**
**Sodener Strasse 9 Postfach 6140**
**D-6231 Schwalbach a. Ts.(DE)**

(54) Anordnung zur berührungslosen Messung des elektrischen Stromsin einem Leiter.

(57) Bei einer Anordnung zur berührungslosen Messung des elektrischen Stroms in einem Leiter (1), bei welcher ein den Leiter umschließender Magnetkern (7) einen Spalt aufweist, in welchem ein Magnetfeldsensor angeordnet ist, ist zwischen den Polflächen des Magnetkerns und dem Magnetfeldsensor ein weichmagnetische Eigenschaften aufweisender Kleber (5) eingebracht.

FIG. 2

Anordnung zur berührungslosen Messung des elektrischen Stroms in einem Leiter.

Die Erfindung betrifft eine Anordnung zur berührungslosen Messung des elektrischen Stroms in einem Leiter, bei welcher ein den Leiter umschließender Magnetkern einen Spalt aufweist, in welchem ein Magnetfeldsensor angeordnet ist.

Derartige Anordnungen werden zur Strommessung verwendet, wenn beispielsweise eine galvanische Trennung zwischen dem zu messenden Strom und einem Meßstromkreis erfolgen soll oder wenn in den Stromkreis kein Widerstand eingefügt werden soll, welcher den Abfall einer Meßspannung bewirkt. Letzteres ist insbesondere bei elektrischen Anlagen von Kraftfahrzeugen der Fall, wo relativ hohe Ströme bei geringen Spannungen auftreten. Bei den bekannten Anordnungen für diesen Zweck ist jedoch die Querschnittsfläche größer als die aktive Fläche des Magnetfeldsensors. Dadurch gehen magnetische Kraftlinien für die Auswertung des Kraftfeldes im Magnetfeldsensor verloren, was zu einer geringen Empfindlichkeit derartiger Anordnungen führt.

Aufgabe der vorliegenden Erfindung ist es, eine Anordnung zur berührungslosen Messung des elektrischen Stroms in einem Leiter anzugeben, bei welchem bereits bei geringem Strom eine auswertbare Spannung am Magnetfeldsensor entsteht.

Die Erfindung ist dadurch gekennzeichnet, daß zwischen den Polflächen des Magnetkerns und dem Magnetfeldsensor ein weichmagnetische Eigenschaften aufweisender Kleber eingebracht ist. Dieses hat den Vorteil, daß sich der Spalt niederer Permeabilität auf den eigentlichen Magnetfeldsensor reduziert, wodurch bei gleichem Strom durch den Leiter die Ausgangsspannung des Magnetfeldsensors größer wird.

Eine Weiterbildung der Erfindung besteht darin, daß die Polflächen des Magnetkerns die Größe der aktiven Fläche des Magnetfeldsensors aufweisen und daß durch eine geeignete Form sichergestellt ist, daß der Kleber sich nur im Bereich der aktiven Fläche des Magnetfeldsensors befindet. Durch diese Weiterbildung ist gewährleistet, daß sich die durch die Anwendung des Klebers erfolgte Verkürzung des Spaltes nur auf die aktive Fläche des Magnetfeldsensors auswirkt.

Gemäß einer anderen Weiterbildung der Erfindung ist vorgesehen, daß der Kleber Teile bildet, deren Querschnittsfläche sich von der Querschnittsfläche des Magnetkerns auf die aktive Fläche des Magnetfeldsensors verjüngt.

Schließlich besteht noch eine andere Weiterbildung darin, daß der Kleber elastische Eigenschaften aufweist. Durch die Verwendung von elastischem Kleber werden mchanische Belastungen durch Änderungen der relativen Lage des Magnetkerns zu einer den Magnetfeldsensor tragenden Leiterplatte weitgehend verhindert.

Derartige Lageänderungen können beispielsweise durch Temperaturänderungen oder Vibration entstehen. Durch die Verwendung von elastischem Kleber wird ferner verhindert, daß durch derartige Beanspruchungen ein Luftspalt gebildet wird.

Die Erfindung läßt zahlreiche Ausführungsformen zu. Zwei davon sind schematisch in der Zeichnung an Hand mehrerer Figuren dargestellt und nachfolgend beschrieben. Es zeigt:

Fig. 1 ein erstes Ausführungsbeispiel und
Fig. 2 ein zweites Ausführungsbeispiel.

Gleiche Teile sind in den Figuren mit gleichen Bezugszeichen versehen.

Dabei wurde für die Darstellung der Figuren eine Größe gewählt, welche für die meisten Anwendungen-insbesondere die Anwendungen im Kraftfahrzeug - eine Vergrößerung bedeutet.

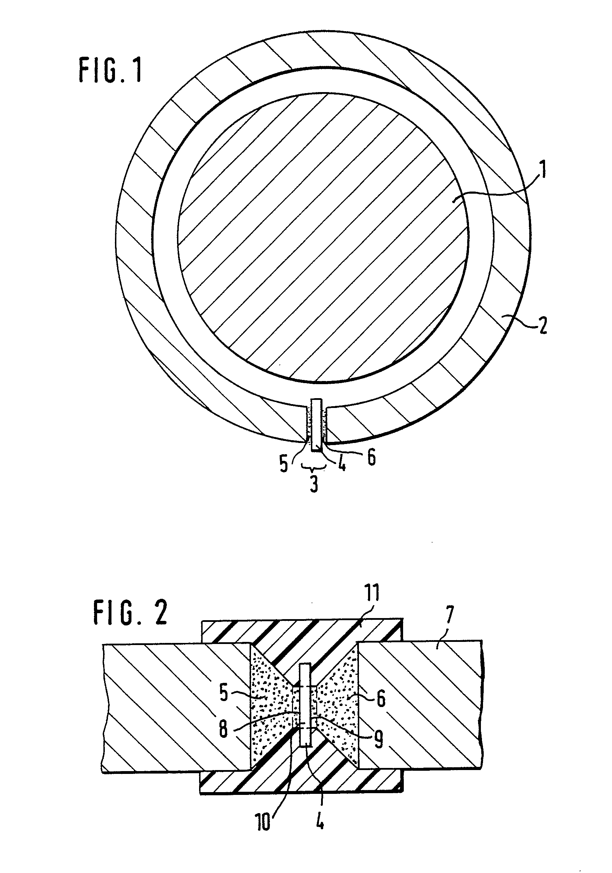

Bei dem Ausführungsbeispiel nach Fig. 1 ist um einen Leiter 1, dessen Strom gemessen werden soll, ein kreisringförmiger Magnetkern 2 angeordnet. In dem Spalt 3 des Magnetkerns 2 ist ein Magnetfeldsensor 4 vorgesehen, dessen Dicke etwas geringer als die Spaltlänge des Magnetkerns 2 ist. Auf beiden Seiten ist der Magnetfeldsensor 4 mit weichmagnetischem Kleber 5, 6 in den Spalt 3 eingeklebt, so daß Zwischenräume mit geringer Permeabilität vermieden sind.

Fig. 2 zeigt lediglich einen vergrößerten Ausschnitt des Magnetkerns 7 im Bereich des Spalts. Die Verjüngung des Querschnitts des Magnetkerns 7 zu den Polflächen 8, 9 erfolgt durch entsprechende Formgebung der aus Kleber bestehenden Teile 5, 6. Dadurch ist eine freie Formgestaltung des Polschuhbereichs möglich. Außerdem werden Lageabweichungen und Verschiebungen zwischen dem Magnetkern 7 und einer nicht dargestellten Halterung des Magnetfeldsensors 4 ausgeglichen, ohne daß es zu unzulässig hohen mechanischen Spannungen zwischen dem Magnetkern 7 und dem Magnetfeldsensor 4 kommt.

Grundsätzlich ist es jedoch auch möglich, die Verjüngung durch entsprechende Formgebung des Magnetkerns 7 auszuführen. Die Polflächen 8, 9 entsprechen der aktiven Fläche 10 des Magnetfeldsensors 4. Dadurch wird erreicht, daß praktisch keine Kraftlinien an der aktiven Fläche vorbei geleitet werden.

Für die Aufnahme des Klebers während des Aushärtevorgangs ist eine Form 11 vorgesehen, welche in nicht 1 dargestellter Weise geteilt ist, um eine Montage zu ermöglichen. Die Form kann aus einem geeigneten Kunststoff bestehen.

## Ansprüche

1. Anordnung zur berührungslosen Messung des elektrischen Stroms in einem Leiter, bei welcher ein den Leiter umschließender Magnetkern einen Spalt aufweist, in welchem ein Magnetfeldsensor angeordnet ist, dadurch gekennzeichnet, daß zwischen den Polflächen des Magnetkerns (2, 7) und dem Magnetfeldsensor (4) ein weichmagnetische Eigenschaften aufweisender Kleber (5, 6) eingebracht ist.

2. Anordnung nach Anspruch 1, dadurch gekennzeichnet , daß die Polflächen (8, 9) des Magnetkerns (7) die Größe der aktiven Fläche (10) des Magnetfeldsensors (4) aufweisen und daß durch eine geeignete Form (11) sichergestellt ist, daß der Kleber (5, 6) sich nur im Bereich der aktiven Fläche (10) des Magnetfeldsensors (4) befindet.

3. Anordnung nach Anspruch 2, dadurch gekennzeichnet, daß der Kleber Teile (5, 6) bildet, deren Querschnittsfläche sich von der Querschnittsfläche des Magnetkerns (7) auf die aktive Fläche (10) des Magnetfeldsensors (4) verjüngt.

4. Anordnung nach Anspruch 1, dadurch gekennzeichnet, daß der Kleber elastische Eigenschaften aufweist.

FIG.1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | PATENT ABSTRACTS OF JAPAN, Band 9, Nr. 221 (P-386)[1944], 7. September 1985; & JP - A - 60 79281 (TOSHIBA) 07.05.1985 ----- | 1 | G 01 R 15/02 G 01 R 33/06 |

RECHERCHIERTE SACHGEBIETE (Int. Cl.4)

G 01 R 15/02
G 01 R 33/06

Der vorliegende Recherchenbericht wurde für alle Patentansprüche erstellt.

| Recherchenort | Abschlußdatum der Recherche | Prüfer |
|---|---|---|
| BERLIN | 29-06-1987 | LEMMERICH J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82